# EUROPÄISCHE PATENTSCHRIFT

(11) **EP 1 124 297 B1**
(45) Veröffentlichungstag und Bekanntmachung des Hinweises auf die Patenterteilung: **24.05.2006**
(21) Anmeldenummer: 01102464.3
(22) Anmeldetag: 03.02.2001
(51) Int. Cl.: H02G 1/12

(54) **Verfahren und Einrichtung zur Abisolierung eines Flachkabels**
Method and device for stripping of a flat cable
Procédé et dispositif de dénudage d'un câble plat

(30) Priorität: 11.02.2000 EP 00810121
(43) Veröffentlichungstag der Anmeldung: 16.08.2001
(73) Patentinhaber: Komax Holding AG, 6036 Dierikon (CH)
(72) Erfinder: Meisser, Claudio, Dipl. El. Ing. ETH, 6330 Cham (CH); Lustenberger, Alois, Dipl. Ing. HTL, 6014 Littau (CH)
(74) Vertreter: Blöchle, Hans

(56) Entgegenhaltungen:
- US-A- 3 385 140
- US-A- 4 999 910

## Beschreibung

Die Erfindung betrifft ein Verfahren bzw. eine Einrichtung zur Abisolierung eines Flachkabels mit in Isolation eingebetteten in Längsrichtung parallel verlaufenden Leitern, wobei die Isolation quer zur Längsrichtung mechanisch bis auf die Leiter entfernt wird.

Aus der Patentschrift US 4 597 176 ist eine Einrichtung bekannt geworden, mittels der Flachkabel abisoliert werden können. Die Isolation des mit mehreren Leitern versehenen Flachkabels wird quer zur Längsachse des Kabels beidseitig mittels Schleifern entfernt. Ein auf Führungen verfahrbarer Schlitten trägt einen Antriebsmotor für die an einem gabelförmigen Arm angeordneten Schleifer, wobei am oberen Gabelende ein Schleifer und am unteren Gabelende ein Schleifer vorgesehen ist. Der Arm wird manuell bewegt, so dass das Flachkabel in Querrichtung vom Arm überdeckt wird. Dabei entfernen die Schleifer an der Oberseite bzw. an der Unterseite des Flachkabels die Isolation bis auf die Leiter.

Ein Nachteil der bekannten Einrichtung liegt darin, dass die Isolation wegen Toleranzen in der Isolationsdicke genügend tief entfernt werden muss, damit die Leiter in jedem Fall ganzflächig frei gelegt sind. Falls die Leiter aus Toleranzgründen höher liegen oder mit weniger Isolation überdeckt sind, werden sie auf der einen Seite durch den Schleifer verletzt und auf der anderen Seite nicht genügend freigelegt.

Aus der Patentschrift US 3 385 140 ist eine Einrichtung zur Abisolierung eines Flachkabels bekannt geworden, bei der zwei gegenläufige Fräserscheiben die Leiter des Flachkabels freilegen. Die eine Fräserscheibe entfernt die Isolation an der Oberseite und die andere Fräserscheibe entfernt die Isolation an der Unterseite des Flachkabels bis auf die Leiter quer zur Leiterachse.

Nachteilig ist bei dieser Einrichtung, dass der Fräsvorgang unkontrolliert oder bestenfalls auf Sicht durchgeführt wird. Beschädigte Leiter durch zu tief fräsende Fräserscheiben sind nicht vermeidbar.

Hier will die Erfindung Abhilfe schaffen. Die Erfindung, wie sie in Anspruch 1 gekennzeichnet ist, löst die Aufgabe, die Nachteile der bekannten Einrichtung zu vermeiden und ein Verfahren bzw. eine Einrichtung vorzuschlagen, mittels dem bzw. mittels der ein Flachkabel zuverlässig abisolierbar ist.

Die durch die Erfindung erreichten Vorteile sind im wesentlichen darin zu sehen, dass trotz toleranzbedingten Abweichungen im Kabelaufbau bzw. in der Isolation die Leiter gleichbleibend gut und vollständig von der Isolation freigelegt werden können, was für die nachfolgenden Schweiss- oder Lötvorgänge wichtig ist. Weiter vorteilhaft ist, dass die Leiter beim Entfernen der Isolation nicht beschädigt werden. Weiter vorteilhaft ist, dass einzelne Leiter an einer beliebigen Stelle des Flachkabels abisoliert werden können.

Dies wird erreicht, indem der Leiter selbst detektiert wird und die Abisolierung in Abhängigkeit eines entsprechenden Signals erfolgt. Bei einer vorteilhaften Ausführungsform erfolgt die vollständige Abisolierung erst nachdem der Leiter bzw. seine Lage gegenüber der Abisolierung detektiert ist. Zweckmässig erfolgt die Detektion des Leiters mittels des Abisolierers bzw. Fräsers. Dabei wird die elektrische Leitfähigkeit des Leiters ausgenützt.

Im folgenden wird die Erfindung anhand von zwei Ausführungsbeispielen darstellenden Zeichnungen näher erläutert.

Es zeigen:
- Fig. 1: ein Flachkabel mit an den Kabelenden über die gesamte Kabelbreite freigelegten Leitern,
- Fig. 2: ein Flachkabel mit an einem Kabelende und/oder an einer beliebigen Stelle des Flachkabels freigelegten Leitern,
- Fig. 3: einen Querschnitt des Flachkabels,
- Fig. 4: eine schematische Darstellung des Vorganges zum Entfernen der Isolation des Flachkabels,
- Fig. 5: einen Ausschnitt des Flachkabels nach dem Freilegen eines Leiters,
- Fig. 6: einen Kabelabschnitt nach dem Freilegen der Leiter der gesamten Kabelbreite,
- Fig. 7: eine Abisoliereinrichtung zum Freilegen der Leiter des Flachkabels,
- Fig. 8 bis Fig. 14: Fräser zum Freilegen der Leiter und eine Einrichtung zum Überwachen des Abisoliervorganges,
- Fig. 15 und Fig. 16: eine höhenverstellbare Vakuumeinheit zum Halten des Flachkabels beim Freilegen der Leiter,
- Fig. 17: eine Einrichtung zum Überprüfen der abisolierten Leiter,
- Fig. 18: eine schematische Darstellung des Hardwaresteuerungsteils der Abisoliereinrichtung,
- Fig. 19: die Parameter zur Steuerung des Abisoliervorganges und
- Fig. 20: ein Flussdiagramm zur Steuerung des Abisoliervorganges.

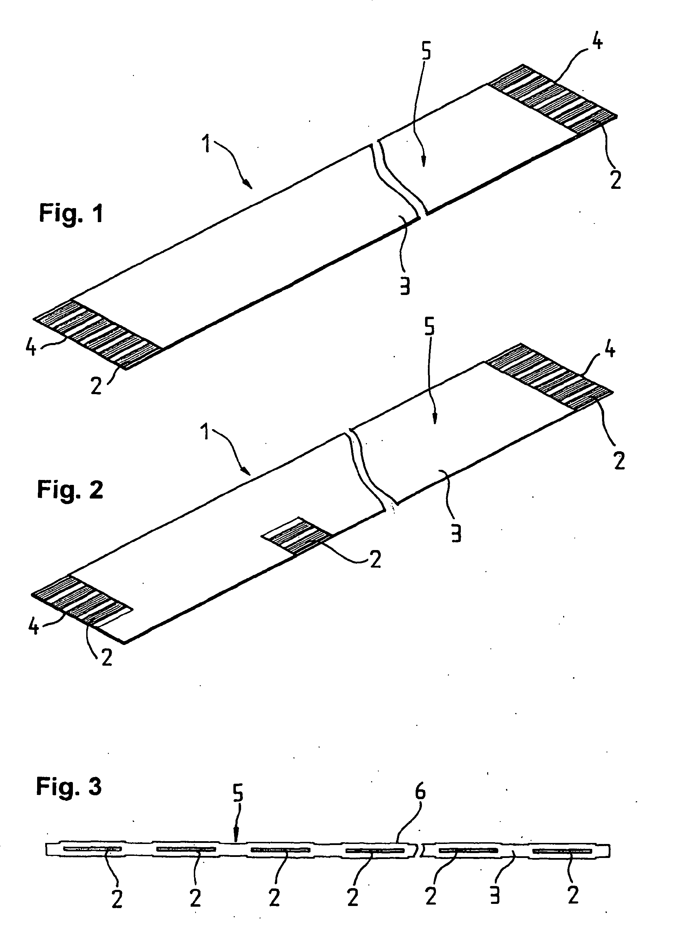

Die Fig. 1 bis 3 zeigen ein Flachkabel 1 mit flachen, in Längsrichtung parallel verlaufenden elektrischen Leitern 2, die in Isolationsmaterial, im weiteren Isolation 3 genannt, eingebettet sind. Fig. 1 zeigt das Flachkabel 1 mit an Kabelenden 4 über die gesamte Kabelbreite an der Oberseite 5 freigelegten Leitern 2. Fig. 2 zeigt das Flachkabel 1 mit einer bestimmten Anzahl freigelegter Leiter 2 am einen Kabelende 4 und mit einer bestimmten Anzahl an einer beliebigen Stelle des Flachkabels 1 freigelegten Leitern 2. Fig. 3 zeigt einen Querschnitt des Flachkabels 1 mit Leitern 2 rechteckförmigen Querschnittes, wobei die Isolation 3 an der Oberfläche Stufen 6 aufweist, die die Leiter 2 überdecken.

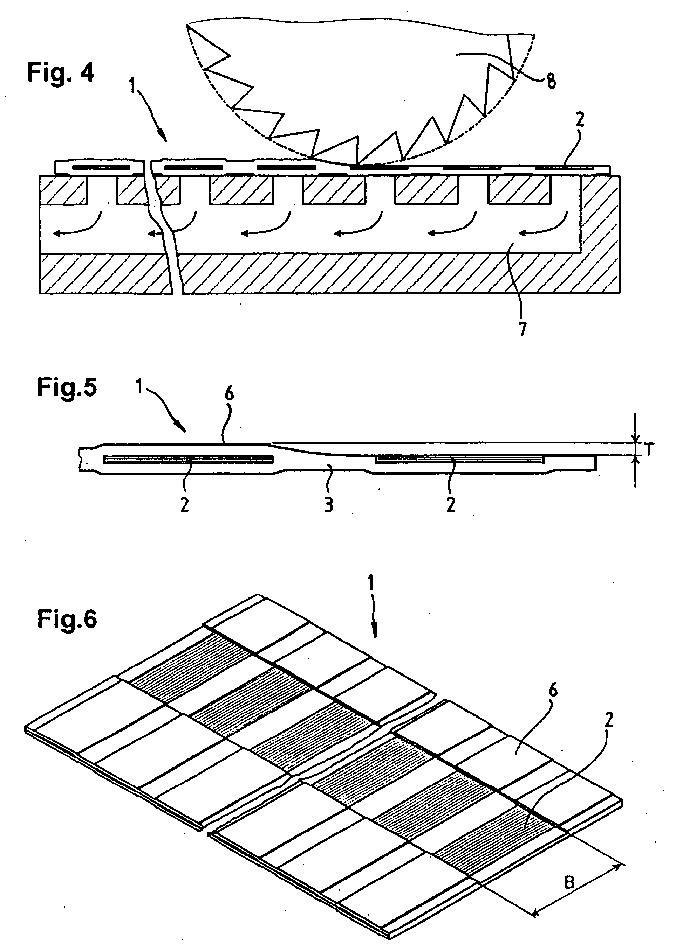

Fig. 4 eine schematische Darstellung des Vorganges zum mechanischen Entfernen der Isolation 3 des Flachkabels 1. Das Flachkabel 1 ist mittels einer Halteeinrichtung 7, beispielsweise mittels eines Vakuumtisches 7 über die gesamte Kabelbreite festgehalten. Ein Abisolierer 8, beispielsweise ein rotierender Fräser 8 entfernt die Isolation 3 an der Oberseite 5 des Flachkabels 1 bis auf die Leiter 2. Fig. 5 zeigt die Isolation 3 des Flachkabels 1 im Bereich eines in der Tiefe T freigelegten Leiters 2. Fig. 6 zeigt einen Kabelabschnitt nach dem Freilegen der Leiter 2 der gesamten Kabelbreite, wobei die minimale Breite B der Abisolierung durch die Breite des Fräsers 8 vorgegeben ist.

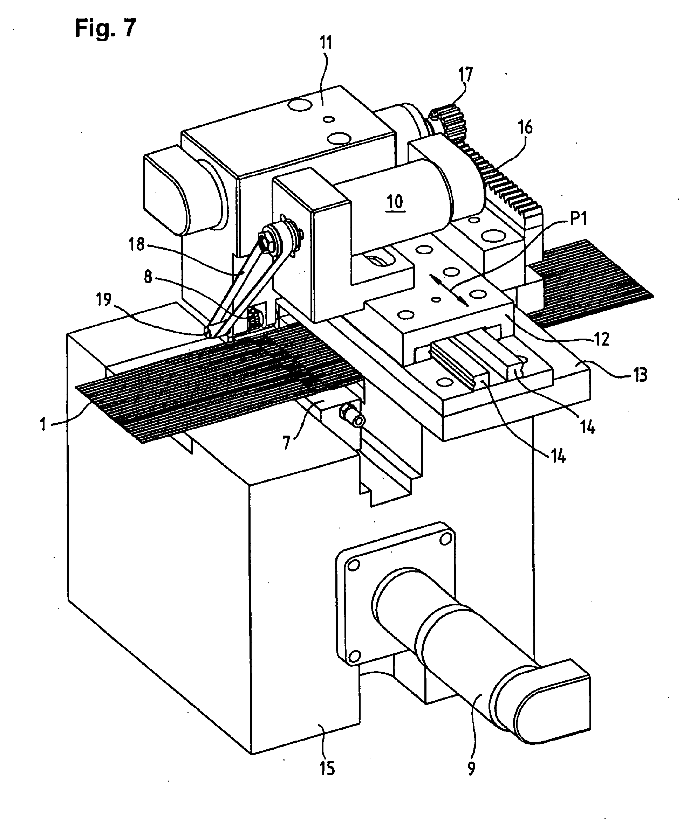

Fig. 7 zeigt eine Abisoliereinrichtung zum Freilegen der Leiter 2 an der Oberseite des Flachkabels 1 mittels dem in Fig. 4 gezeigten Abisolierer 8. Die Einrichtung besteht im wesentlichen aus dem in Fig. 4 gezeigten Vakuumtisch 7, aus einem Tischantrieb 9, aus einem Fräserantrieb 10 und aus einem auf einem Schlitten 12 angeordneten Vorschubantrieb 11, der den Fräserantrieb 10 mitsamt dem Fräser 8 auf dem Schlitten 12 in der mit einem Pfeil P1 symbolisierten Richtung bewegt. Nicht dargestellt ist eine beim Fräser 8 angeordnete Absaugvorrichtung. Der Schlitten 12 wird mittels an einem Gehäusetisch 13 angeordneten Führungsschienen 14 geführt. Der Gehäusetisch 13 wird von einem Gehäuse 15 getragen, an dem auch der Tischantrieb 9 angeordnet ist. Der beispielsweise aus einem Motor und einem Getriebe bestehende Vorschubantrieb 11 bewegt sich mittels eines Ritzels 17 entlang einer am Gehäuse 15 angeordneten Zahnstange 17 und führt die mit dem Pfeil P1 symbolisierte Bewegung des Schlittens 12 aus. Der Fräserantrieb 10 treibt beispielsweise mittels eines Riemens 18 ein mit dem Fräser 8 verbundenes Pulley 19 an.

Zur Entfernung der Isolation an der Unterseite des Flachkabels 1 ist ein unterhalb des Flachkabels 1 angeordneter Vorschubantrieb und Fräserantrieb mit Fräser vorgesehen, wobei ein oberhalb des Flachkabels 1 angeordneter höhenverstellbarer Vakuumtisch vorgesehen ist. Die Abisoliereinrichtung für die Abisolierung an der Unterseite des Flachkabels funktioniert gleich wie die Abisoliereinrichtung für die Abisolierung an der Oberseite 5 des Flachkabels 1.

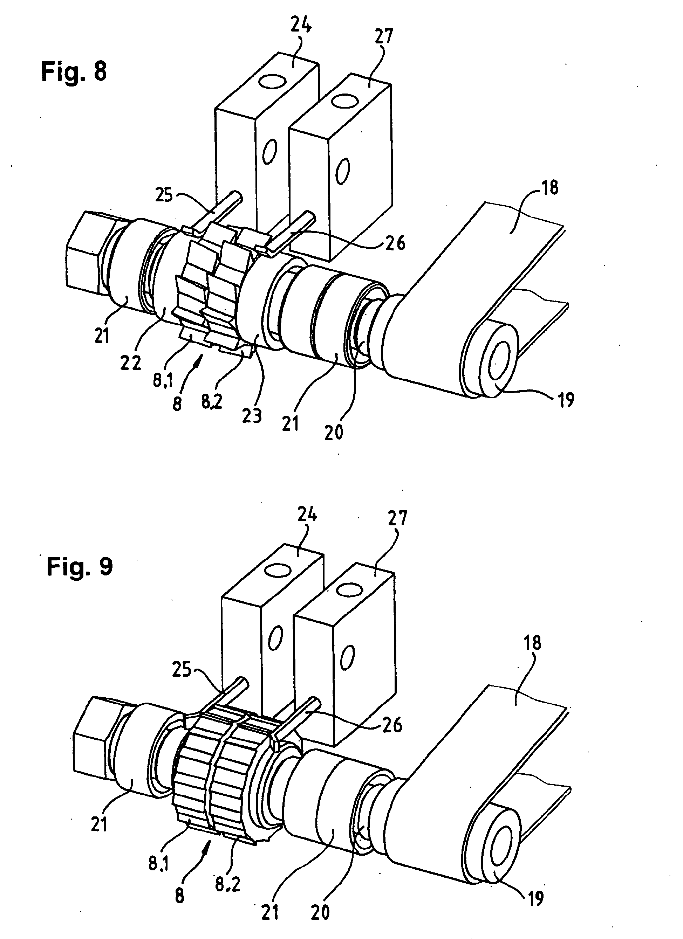

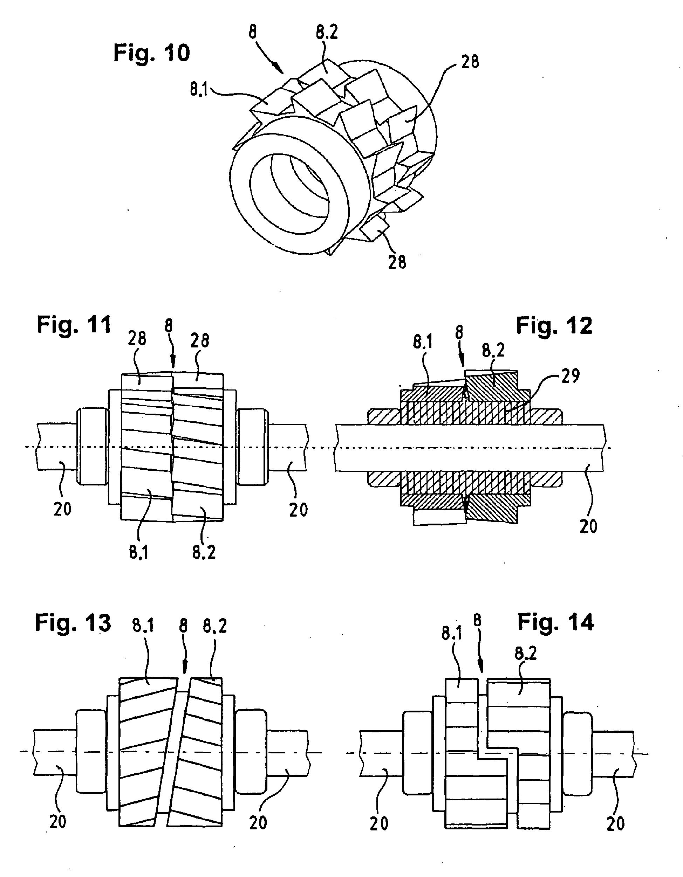

Fig. 8 bis Fig. 14 zeigen den Fräser 8 zum Freilegen der Leiter 2 und eine Einrichtung zum Überwachen des Abisoliervorganges. Der Fräser besteht aus einer ersten Fräserhälfte 8.1 und aus einer zweiten Fräserhälfte 8.2. wobei die Fräserhälften 8.1,8.2 von einer ersten Welle 20 getragen werden. Die Welle 20 ist an ersten Lagern 21 gelagert, wobei am einen Wellenende das vom Riemen 18 angetriebene Pulley 19 angeordnet ist. Die Fräserhälften 8.1,8.2 sind gegeneinander elektrisch isoliert, wobei die erste Fräserhälfte 8.1 elektrisch mit einem ersten Schleifring 22 und die zweite Fräserhälfte 8.2 elektrisch mit einem zweiten Schleifring 23 verbunden ist. Die Schleifringe 22,23 sind gegenüber der Welle 20 elektrisch isoliert. Ein Sender 24 speist ein elektrisches Signal mittels eines ersten Schleifkontaktes 25 auf den ersten Schleifring 22. Falls beide Fräserhälften 8.1,8.2 Kontakt mit dem freizulegenden elektrischen Leiter 2 haben, wird das Signal von der ersten Fräserhälfte 8.1 über den Leiter 2 auf die zweite Fräserhälfte 8.2 geleitet und von diesem auf den zweiten Schleifring 23. Vom zweiten Schleifring 23 gelangt das Signal mittels eines zweiten Schleifkontaktes 26 zu einem Empfänger 27. Aufgrund des am Empfänger festgestellten Signales wird der Vakuumtisch 7 zumindest nicht mehr weiter angehoben. Fig. 9 zeigt eine Variante ohne Schleifringe, wobei der erste Schleifkontakt 25 direkt mit der ersten Fräserhälfte 8.1 und der zweite Schleifkontakt 26 direkt mit der zweiten Fräserhälfte 8.2 verbunden ist. Fig. 10 bis Fig. 12 zeigen Einzelheiten des Fräsers 8 und dessen isolierte Anordnung an der Welle 20. Die Fräserhälften 8.1,8.2 weisen Zähne 28 auf, die an der benachbarten Seite der Fräserhälften 8.1,8.2 überlappend sind ohne sich zu berühren. Mit den überlappenden Zähnen 28 wird sichergestellt, dass beim Fräsen der Isolation 3 zwischen den Fräserhälften 8.1,8.2 kein Isolationsgrat entsteht. Fig. 12 zeigt einen Schnitt durch die Fräserhälften 8.1,8.2, die an einem von der Welle 20 getragenen Isolierstück 29 angeordnet sind. Fig. 13 und Fig. 14 zeigen Ausführungsvarianten der Fräserhälften 8.1,8.2 ohne überlappende Zähne, wobei die Fräserhälften 8.1,8.2 so geformt sind, dass beim Fräsen kein Isolationsgrat entstehen kann.

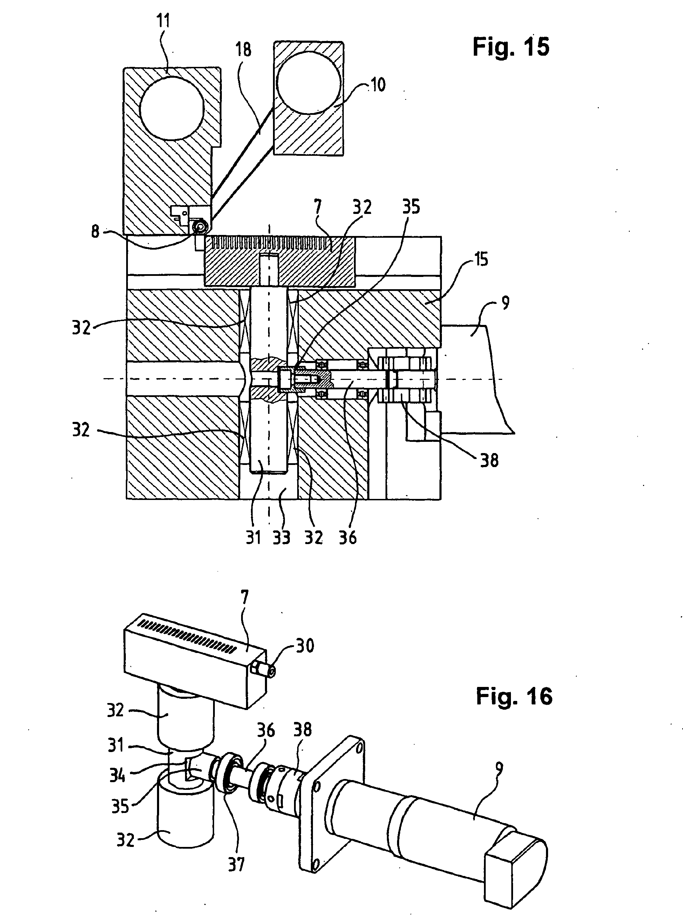

Fig. 15 und Fig. 16 zeigen den höhenverstellbaren Vakuumtisch 7 zum Halten des Flachkabels 1 beim Freilegen der Leiter 2. Der Vakuumtisch 7 mit einem Vakuumanschluss 30 weist einen Stössel 31 mit dritten Lagern 32 auf, die in einer Bohrung 33 des Gehäuses 15 geführt sind. Am Stössel 31 ist eine Ausnehmung 34 vorgesehen, in die ein Exzenterzapfen 35 einer zweiten Welle 36 greift. Die an zweiten Lagern 37 gelagerte zweite Welle 36 ist mittels einer Kupplung 38 mit dem Tischantrieb 9 verbunden. Beim Drehen der zweiten Welle 36 bewegt der exzentrisch zur Wellenachse angeordnete Exzenterzapfen 35 den Stössel 31 und somit den Vakuumtisch 7 auf bzw. ab, wobei sich die Bewegung in sehr kleinen Bereichen abspielt. Die Höhenverstellung erfolgt abhängig von der Position des Vorschubantriebes 11 und vom am Empfänger 27 anstehenden Signal. Anstelle des Vakuumtisches 7 kann der Fräser 8 höhenverstellbar sein.

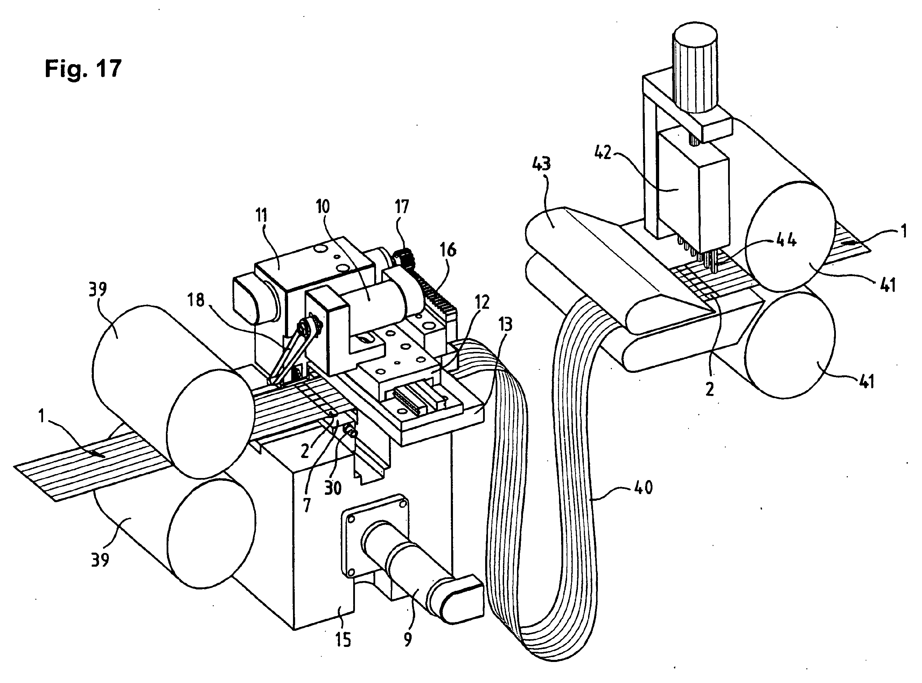

Fig. 17 zeigt eine Einrichtung zum Überprüfen der abisolierten Leiter 2. Das Flachkabel 1 wird mittels eines ersten Kabelvorschubes 39 transportiert und wie oben dargestellt abisoliert. Danach wird das Flachkabel 1 um ein bestimmtes Mass vorgeschoben und erneut abisoliert. Am Ausgang der Abisoliereinrichtung bildet das Flachkabel 1 eine Schlaufe 40, die von einem zweiten Kabelvorschub 41 abgezogen wird. Das Flachkabel 1 wird soweit abgezogen, bis sich die freigelegten Leiter 2 unter einer Prüfeinheit 42 befinden. Dann wird das Flachkabel 1 mittels einer Führungsvorrichtung 43 festgehalten und je Leiter 2 ein federnder Prüfkontakt 44 auf den abisolierten Leiter 2 abgesenkt. Mit der Prüfeinheit 42 wird geprüft, ob Leiter 2 gegeneinander kurzgeschlossen sind und/oder ob Leiter 2 unterbrochen sind.

In einer weiteren Variante kann mit der Prüfeinheit 42 auch der Abisoliervorgang des Fräsers 8 überwacht werden. In diesem Fall kann ein einstückiger Fräser 8 verwendet werden, an dem der Sender 24 sein Signal einspeist.
Aufgrund des von der Prüfeinheit 42 festgestellten Signales wird der Vakuumtisch 7 gesteuert. Mit dieser Variante kann auch festgestellt werden, ob Leiter 2 unterbrochen sind.

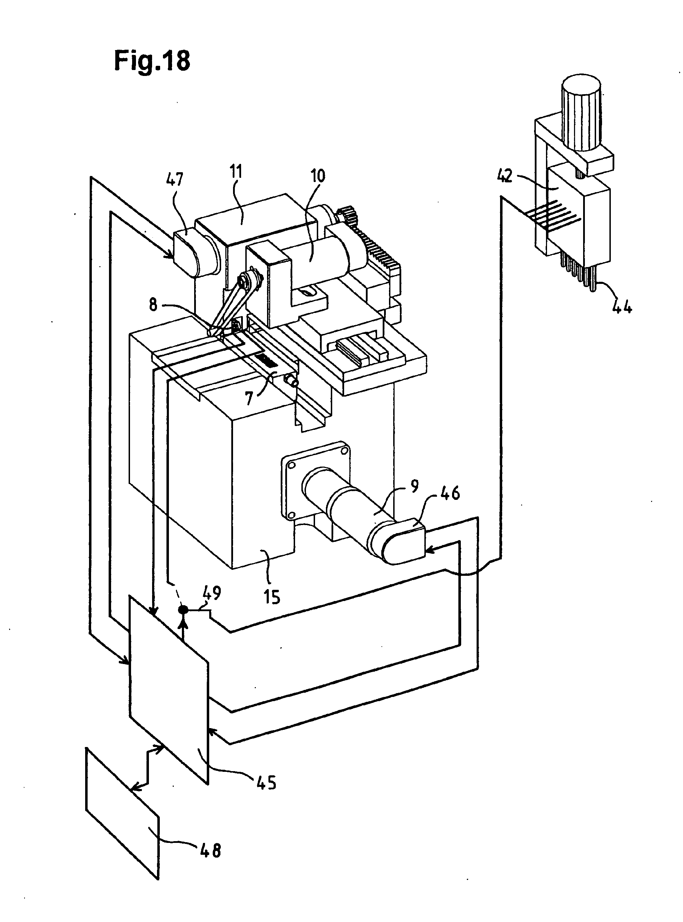

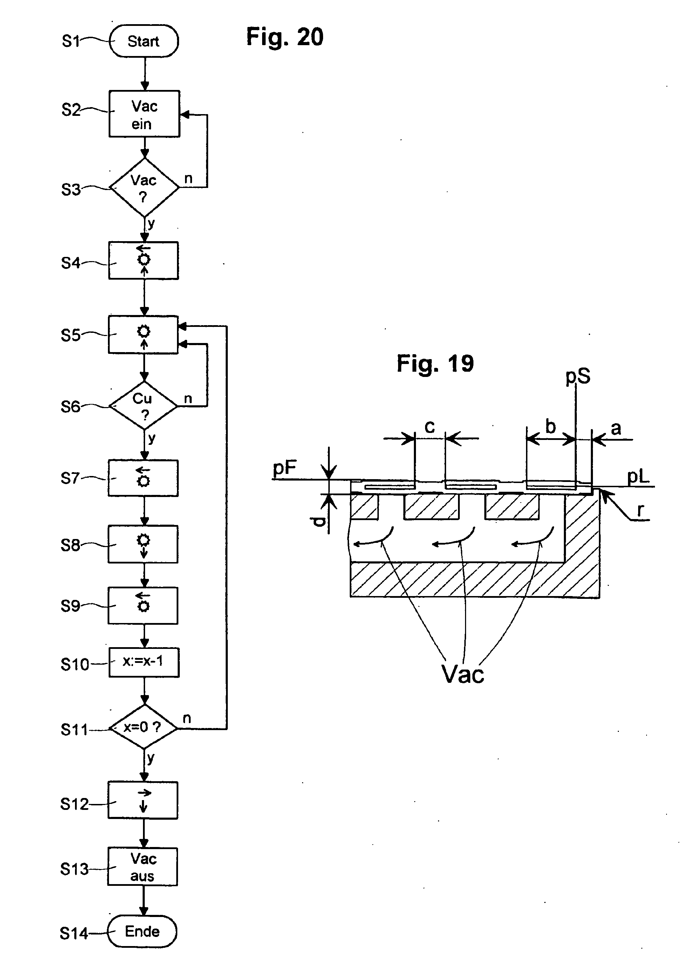

Fig. 18 zeigt eine schematische Darstellung des Hardwaresteuerungsteils der Abisoliereinrichtung. Eine Schnittstelle 45 erfasst die Signale der Prüfkontakte 44, des Fräsers 8, eines am Tischantrieb 9 angeordneten Sensors 46 zur Erfassung der Drehposition des Tischantriebes 9 und eines am Vorschubantrieb 11 angeordneten Sensors 47 zur Erfassung der Drehposition des Vorschubantriebes 11. Die Daten werden an eine Steuerung 48 mit Rechner weitergeleitet, der anhand der Daten und eines Programmes Steuerdaten für den Tischantrieb 9 und den Vorschubantrieb 11 generiert. Mit den Steuerungsdaten erzeugt die Schnittstelle 45 Steuersignale für den Tischantrieb 9 und den Vorschubantrieb 11. Wie im vorhergehenden Abschnitt erwähnt, kann mit der Prüfeinheit 42 auch der Abisoliervorgang des Fräsers 8 überwacht werden. In diesem Fall wird das Prüfsignal mittels des symbolisch dargestellten Schalters 49 auf die Prüfkontakte 44 geleitet. Sobald der Fräser 8 einen Leiter 2 erreicht, ist der Stromkreis geschlossen. Die Steuerung 48 generiert dann wie in Fig. 20 gezeigt die entsprechenden Steuerdaten für den Tischantrieb 9 und den Vorschubantrieb 11.

Fig. 19 zeigt die Parameter zur Steuerung des Abisoliervorganges. Die obere äussere Kante des Vakuumtisches 7 ist als Referenzpunkt r für die Steuerung 48 vorgesehen. a ist die Randbreite des Flachkabels 1. Mit ps ist die Startposition des Fräsers 8 bezeichnet. b ist die Breite des Leiters 2 und c der Abstand zwischen zwei Leitern 2. d ist die Dicke des Flachkabels 1. pF ist die Kabelposition und pL ist die Leiterposition, wobei vom Vakuumtisch 7 her gesehen pF - pL = T ist.

Fig. 20 zeigt den Ablauf des Abisoliervorganges. Mit dem Schritt S1 wird der Abisoliervorgang gestartet und im Schritt S2 das Vakuum Vac des Vakuumtisches 7 aufgebaut. Im Schritt S3 wird geprüft, ob das notwendige Vakuum Vac vorhanden ist. Das Vakuum Vac wird im Verlauf des Abisoliervorganges laufend überprüft. Bei abnormalem Vakuum Vac wird die Abisoliereinrichtung stillgesetzt und eine Fehlermeldung erzeugt. Abnormales Vakuum Vac kann beispielsweise entstehen, falls der Fräser 8 das Flachkabel 1 beschädigt oder mitreisst oder vom Vakuumtisch 7 abhebt. Im Schritt S4 wird der Fräser 8 in die Startposition ps gebracht und der Vakuumtisch 7 angehoben. Die Bewegung des Fräsers 8 von einer Anfangsposition in die Startposition ps ist mit einem oben angeordneten Pfeil nach links und die Rotationsbewegung des Fräsers 8 ist mit einem mittig angeordneten Kreis symbolisiert. Der Vakuumtisch 7 wird angehoben, bis die Oberseite 5 des Flachkabels 1 bündig mit der Kabelposition pF ist. Die Bewegung des Vakuumtisches 7 ist mit einem unten angeordneten Pfeil nach oben symbolisiert. Die symbolisierte Darstellung der Bewegungsrichtungen und der Rotationsbewegung gilt für die folgenden Schritte sinngemäss. In den Schritten S5 und S6 wird der Vakuumtisch 7 weiter angehoben, bis wie weiter oben dargestellt das Material Cu des Leiters 2 mittels des Fräsers 8 feststellbar ist. Im Schritt S7 wird der rotierende Fräser 8 mittels des Vorschubantriebes 11 um die Breite b des Leiters 2 nach links bewegt, wobei der Leiter 2 freigelegt wird. Im Schritt S8 wird der Vakuumtisch 7 um pF - pL abgesenkt. Der rotierende Fräser 8 wird dann im Schritt S9 um den Abstand c zwischen zwei Leitern 2 mittels des Vorschubantriebes 11 nach links bewegt. Im Schritt S10 wird die Anzahl x der noch frei zu legenden Leiter 2 um eine Einheit vermindert und im Schritt S11 geprüft, ob noch frei zu legende Leiter 2 vorhanden sind. Falls noch Leiter 2 freizulegen sind, wird der Abisoliervorgang mit dem Schritt S5 fortgesetzt. Nachdem alle Leiter 2 freigelegt sind, wird mit dem Schritt S12 der Vakuumtisch 7 in die Ausgangslage abgesenkt und der Fräser 8 mittels des Vorschubantriebes 11 in die Startposition ps gebracht. Im Schritt S13 wird das Vakuum Vac des Vakuumtisches 7 ausgeschaltet und der Abisoliervorgang mit dem Schritt S14 beendet.

## Patentansprüche

1. Verfahren zur Abisolierung eines Flachkabels (1) mit in Isolation (3) eingebetteten in Längsrichtung parallel verlaufenden Leitern (2), wobei die Isolation (3) quer zur Längsrichtung mechanisch bis auf die Leiter (2) entfernt wird,
**dadurch gekennzeichnet,**
**dass** die Abisolierung in Abhängigkeit eines elektrischen Signales zur Detektion eines Leiters (2) erfolgt, wobei die Abisolierung an der Längskante des Leiters (2) beginnt und die vollständige Abisolierung erst erfolgt nachdem der Leiter (2) detektiert ist.

2. Verfahren nach Anspruch 1,
**dadurch gekennzeichnet,**
**dass** mindestens ein Leiter (2) des Flachkabels (1) abisolierbar ist.

3. Einrichtung zum Abisolieren eines Flachkabels (1) mit in Isolation (3) eingebetteten in Längsrichtung parallel verlaufenden Leitern (2), wobei die Isolation (3) quer zur Längsrichtung mittels einer Abisoliereinrichtung bis auf die Leiter (2) entfernbar ist,
**dadurch gekennzeichnet,**
**dass** eine Einrichtung zur elektrischen Detektion eines von der Isolation (3) freigelegten Leiters (2) vorgesehen ist, wobei die Abisoliereinrichtung (7,9,10,11) in Abhängigkeit der elektrischen Detektion des freigelegten Leiters (2) steuerbar ist und eine Signalquelle (24) vorgesehen ist, deren elektrisches Signal über einen Abisolierer (8) und von diesem über den freigelegten Leiter (2) leitbar ist und dass eine Empfangseinrichtung (27,42) vorgesehen ist, die das elektrische Signal detektiert.

4. Einrichtung nach Anspruch 3,
**dadurch gekennzeichnet,**
**dass** ein Abisolierer (8) mit zwei elektrisch isolierten Hälften (8.1,8.2) vorgesehen ist, wobei das Signal auf eine Hälfte (8.1) und von dieser auf den freigelegten Leiter (2) und von diesem auf die andere Hälfte (8.2) und von dieser auf einen Empfänger (27) leitbar ist.

5. Einrichtung nach einem der Ansprüche 3 oder 4,
**dadurch gekennzeichnet,**
**dass** ein elektrisch isolierter Abisolierer (8) vorgesehen ist, wobei das Signal vom Abisolierer (8) auf den freigelegten Leiter (2) und von diesem auf den vorausliegenden freigelegten Leiter und von diesem auf eine Prüfeinheit (42) leitbar ist.

6. Einrichtung nach einem der vorhergehenden Ansprüche,
**dadurch gekennzeichnet,**
**dass** eine höhenverstellbare Einrichtung (7,9) vorgesehen ist, mittels der die Abisolierung des Leiters (2) steuerbar ist.

7. Einrichtung nach Anspruch 6,
**dadurch gekennzeichnet,**
**dass** ein Vakuumtisch (7) zum Halten und Höhenverstellen des Flachkabels (1) gegenüber dem Abisolierer (8) vorgesehen ist.

## Claims

1. Method of removing insulation from a flat cable (1) with conductors (2) embedded in insulation (3) and extending parallelly in longitudinal direction, wherein the insulation (3) is mechanically removed transversely to the longitudinal direction as far as the conductors (2), **characterised in that** the insulation removal is carried out in dependence on an electrical signal for detection of a conductor (2), wherein the insulation removal begins at the longitudinal edge of the conductor (2) and the complete insulation removal is carried out only after the conductor (2) is detected.

2. Method according to claim 1, **characterised in that** at least one conductor (2) of the flat cable (1) is able to be stripped of insulation.

3. Equipment for removing insulation from a flat cable (1) with conductors (2) embedded in insulation (3) and extending parallelly in longitudinal direction, wherein the insulation (3) is removable transversely to the longitudinal direction as far as the conductors (2) by means of insulation removing equipment, **characterised in that** a device for electrical detection of a conductor (2) freed from the insulation (3) is provided, wherein the insulation removal equipment (7, 9, 10, 11) is controllable in dependence on the electrical detection of the exposed conductor (2) and a signal source (24) is provided, the electrical signal of which can be conducted by way of an insulation removal device (8) and from this by way of the exposed conductor (2), and that a receiver device (27, 42) which detects the electrical signal is provided.

4. Equipment according to claim 3, **characterised in that** an insulation removal device (8) with two electrically insulated halves (8.1, 8.2) is provided, wherein the signal can be conducted to one half (8.1), from this to the exposed conductor (2), from this to the other half (8.2) and from this to a receiver (27).

5. Equipment according to one of claims 3 and 4, **characterised in that** an electrically insulated insulation removal device (8) is provided, wherein the signal can be conducted from the insulation removal device (8) to the exposed conductor (2), from this to the previously exposed conductor and from this to a checking unit (42).

6. Equipment according to one of the preceding claims, **characterised in that** a device (7, 9) adjustable in height is provided, by means of which the removal of insulation from the conductor (2) is controllable.

7. Equipment according to claim 6, **characterised in that** a vacuum table (7) for holding and adjusting the height of the flat cable (1) relative to the insulation removal device (8) is provided.

## Revendications

1. Procédé pour dénuder un câble plat (1) contenant des conducteurs (2) qui sont enrobés dans une isolation (3) et qui s'étendent parallèlement dans le sens longitudinal, l'isolation (3) étant enlevée mécaniquement, transversalement par rapport au sens longitudinal, jusqu'aux conducteurs (2),
**caractérisé en ce que** le dénudage se fait en fonction d'un signal électrique pour la détection d'un conducteur (2), le dénudage commençant par le bord longitudinal du conducteur (2) et le dénudage complet ne se faisant qu'une fois que le conducteur (2) est détecté.

2. Procédé selon la revendication 1, **caractérisé en ce qu'**au moins un conducteur (2) du câble plat (1) est apte à être dénudé.

3. Dispositif pour dénuder un câble plat (1) contenant des conducteurs (2) qui sont enrobés dans une isolation (3) et qui s'étendent parallèlement dans le sens longitudinal, l'isolation (3) étant apte à être enlevée mécaniquement à l'aide d'un dispositif de dénudage, transversalement par rapport au sens longitudinal, jusqu'aux conducteurs (2),
**caractérisé en ce qu'**il est prévu un dispositif pour la détection électrique d'un conducteur (2) débarrassé de l'isolation (3), étant précisé que le dispositif de dénudage (7, 9, 10, 11) est apte à être commandé en fonction de la détection électrique du conducteur (2) dégagé et qu'il est prévu une source de signal (24) dont le signal électrique est apte à passer par un appareil de dénudage (8) et, à partir de celui-ci, par le conducteur (2) dégagé, et **en ce qu'**il est prévu un dispositif de réception (27, 42) qui détecte le signal électrique.

4. Dispositif selon la revendication 3, **caractérisé en ce qu'**il est prévu un appareil de dénudage (8) avec deux moitiés (8.1, 8.2) isolées électriquement, le signal étant apte à être transmis à une moitié (8.1) puis, de celle-ci, au conducteur (2) dégagé et, de celui-ci, à l'autre moitié (8.2) puis, de celle-ci, à un récepteur (27).

5. Dispositif selon la revendication 3 ou 4, **caractérisé en ce qu'**il est prévu un appareil de dénudage (8) isolé électriquement, le signal étant apte à être transmis à partir de l'appareil de dénudage (8) au conducteur (2) dégagé puis, de celui-ci, au conducteur dégagé situé en avant et, de celui-ci, à une unité de contrôle (42).

6. Dispositif selon l'une des revendications précédentes, **caractérisé en ce qu'**il est prévu un dispositif réglable en hauteur (7, 9) grâce auquel le dénudage du conducteur (2) peut être commandé.

7. Dispositif selon la revendication 6, **caractérisé en ce qu'**il est prévu un plateau à vide (7) pour tenir et régler en hauteur le câble plat (1) par rapport à l'appareil de dénudage (8).
